(19) Europäisches Patentamt / European Patent Office / Office européen des brevets

(11) **EP 4 212 278 A1**

(12) **EUROPEAN PATENT APPLICATION**
published in accordance with Art. 153(4) EPC

(43) Date of publication:
**19.07.2023 Bulletin 2023/29**

(21) Application number: **22758416.6**

(22) Date of filing: **01.03.2022**

(51) International Patent Classification (IPC):
**B23K 35/26** (2006.01)   **B23K 35/22** (2006.01)
**C22C 13/02** (2006.01)   **H05K 3/00** (2006.01)

(86) International application number:
**PCT/JP2022/008701**

(87) International publication number:
**WO 2023/100383 (08.06.2023 Gazette 2023/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.11.2021 JP 2021194984**

(71) Applicant: **Tamura Corporation**
**Tokyo 178-8511 (JP)**

(72) Inventors:
• **NARUSE, Shouichirou**
**Iruma-shi, Saitama 358-0032 (JP)**
• **NAKANO, Takeshi**
**Iruma-shi, Saitama 358-0032 (JP)**
• **SAKAMOTO, Isao**
**Iruma-shi, Saitama 358-0032 (JP)**
• **SHIMADA, Toshiaki**
**Iruma-shi, Saitama 358-0032 (JP)**
• **OKUBO, Koichi**
**Iruma-shi, Saitama 358-0032 (JP)**

(74) Representative: **Cabinet Beau de Loménie**
**158, rue de l'Université**
**75340 Paris Cedex 07 (FR)**

(54) **SOLDER ALLOY, SOLDER JOINING MEMBER, SOLDER PASTE, AND SEMICONDUCTOR PACKAGE**

(57)    Providing a solder alloy, a solder bonding material, a solder paste, and a semiconductor package capable of suppressing peeling between a solder bonding portion and a semiconductor element at an interface between the solder bonding portion and the semiconductor element.

A solder alloy of the present invention comprises 1.1% by mass or more and 8% by mass or less of Cu, 6% by mass or more and 20% by mass or less of Sb, 0.01% by mass or more and 0.5% by mass or less of Ni, and 0.001% by mass or more and 1% by mass or less of Co, and the balance being Sn.

*FIG. 1*

**Description**

Technical Field

The present invention relates to a solder alloy, a solder bonding material, a solder paste, and a semiconductor package.

Background Art

A semiconductor package (semiconductor package refers to an electronic component in which semiconductor elements are packaged) used for an electronic device is produced by, for example, bonding (die bonding) semiconductor elements (for example, a semiconductor chip) onto a substrate by using a bonding material, and further wire bonding or the like, and molding with a molding resin or the like.

There are various defects occurring in the semiconductor package, and one of the causes thereof is a bonding failure between the semiconductor element and the substrate. This bonding failure is often caused by a bonding material. As a bonding material that suppresses such bonding failure, for example, solder bonding materials disclosed in the following Patent Literature 1 to Patent Literature 3 have been proposed.

Patent Literature 1 discloses a solder material capable of suppressing a decrease in thermal conductivity at a high temperature for the purpose of suppressing a decrease in thermal conductivity of a solder portion due to repeated heat generation of a semiconductor element and deterioration of the solder portion caused thereby, specifically, a solder material composed of Sb in an amount of more than 5.0% by mass and 10.0% by mass or less, Ag in an amount of 2.0 to 4.0% by mass, and Ni in an amount of 0.1 to 0.4% by mass with the balance being Sn and inevitable impurities.

Patent Literature 2 discloses a solder bonding portion including a solder bonding layer in which a solder material composed of more than 5.0% by mass and 10.0% by mass or less of Sb, 2.0 to 4.0% by mass of Ag, and 0.01 to 1.0% by mass of Ni, the balance being Sn and inevitable impurities, is melted, and a bonded body which is a Cu or a Cu alloy member, in which the solder bonding layer includes a first structure containing $(Cu,Ni)_6(Sn,Sb)_5$ and a second structure containing $(Ni,Cu)_3(Sn,Sb)_4$ at an interface with the Cu or Cu alloy member, for the purpose of suppressing a crack in the solder portion due to repeated heat generation of a semiconductor element and suppressing peeling between the solder portion and a substrate caused by the crack.

Patent Literature 3 discloses a semiconductor device including a semiconductor element and a bonding layer in which a solder material is melted, in which the solder material is composed of Sb in an amount of more than 5.0% by mass and 10.0% by mass or less, Ag in an amount of 2.0 to 4.0% by mass, and Ni in an amount of 0.1 to 0.4% by mass with the balance being Sn and inevitable impurities, for the purpose of suppressing a decrease in thermal conductivity of a solder portion due to repeated heat generation of the semiconductor element and suppressing deterioration of the solder portion caused thereby.

Citation List

Patent Literature

Patent Literature 1: Japanese Patent No. 6516013
Patent Literature 2: Japanese Patent No. 6642865
Patent Literature 3: Japanese Patent No. 6773143

Summary of Invention

Technical Problem

Meanwhile, thin films of Ti, Ni, and the like are generally formed in order from a semiconductor element side on a back electrode of the semiconductor element, particularly of a power semiconductor element. The Ni film is formed for bonding the power semiconductor element and a bonding material (in particular, a solder bonding material).

In addition, the solder bonding material including Sn is often used.

Therefore, during solder bonding between the power semiconductor element and a substrate, the Ni film and Sn included in the solder bonding material can precipitate a Ni-Sn intermetallic compound. The Ni-Sn intermetallic compound is present at the interface between a solder bonding portion and the power semiconductor element, and can improve the bonding strength between them.

Herein, a power semiconductor element, for example, a Si element (silicon element, for example, silicon chip), self-heats during operation and a temperature thereof becomes high. In addition, heat generated from the Si element is released to the outside through the solder bonding portion, the substrate, a heat dissipation substrate in a power semiconductor package, and the like, and therefore the Si element that is not in operation is in a cooled state.

Therefore, a repeated thermal load is applied to the solder bonding portion in contact with the Si element that repeats heat generation and cooling. This repeated thermal load promotes diffusion of the Ni-Sn intermetallic compound present at the interface between the solder bonding portion and the Si element, or diffusion of the Ni film into the solder bonding portion.

As described above, the Ni film and the Ni-Sn intermetallic compound contribute to improvement of bonding strength between the Si element and the solder bonding portion. Therefore, diffusion of these into the solder bonding portion decreases the bonding strength between them. In addition, if this diffusion continues, the composition (component) contributing to the bonding between them disappears, and thus, peeling at the interface may occur. This peeling phenomenon particularly leads to a decrease in reliability of the power semiconductor package (in the present description, meaning a semiconductor package using a power semiconductor element).

In recent years, there is an increasing demand for power semiconductor packages that can handle higher voltages and larger currents. Therefore, the use of power semiconductor elements tends to increase that have higher performance and are capable of handling higher voltages and larger currents, such as a SiC element, a GaN element, and a $Ga_2O_3$ element, and the like (hereinafter, these are referred to as a "next-generation power semiconductor element").

The next-generation power semiconductor element is superior in heat resistance to the Si element and operates at higher temperature. Therefore, in the power semiconductor package using the next-generation power semiconductor element, heat applied to the solder bonding portion further increases. Therefore, in this case, the diffusion of the Ni film and the Ni-Sn intermetallic compound into the solder bonding portion and the peeling phenomenon caused by the diffusion tend to easily occur.

However, Patent Literature 1 to Patent Literature 3 do not disclose or suggest such a phenomenon.

A purpose of the present invention is to solve the above problems, and to provide a solder alloy, a solder bonding material, a solder paste, and a semiconductor package capable of suppressing peeling of a solder bonding portion and a semiconductor element at the interface between them.

Solution to Problem

A solder alloy of the present invention comprises 1.1% by mass or more and 8% by mass or less of Cu, 6% by mass or more and 20% by mass or less of Sb, 0.01% by mass or more and 0.5% by mass or less of Ni, and 0.001% by mass or more and 1% by mass or less of Co, and the balance being Sn.

An amount of Cu (% by mass) and an amount of Ni (% by mass) in the solder alloy preferably satisfy following formula (A).

```
The amount of Ni/(the amount of Cu + the amount of

Ni) < 0.10...   (A)
```

The solder alloy preferably further comprises 0.1% by mass or more and less than 3% by mass of Ag.

The solder alloy preferably further comprises at least one of Al, Ti, Si, Fe, and Ge in a total amount of 0.003% by mass or more and 0.5% by mass or less.

A solder bonding material of the present invention comprises the solder alloy.

In addition, a solder paste of the present invention comprises a powder composed of the above mentioned solder alloy, and a flux.

In addition, a semiconductor package of the present invention is a semiconductor package comprising a substrate, a semiconductor element, and a bonding portion bonding the substrate and the semiconductor element, wherein bonding portion is formed by using the above mentioned solder bonding material.

In addition, a semiconductor package of the present invention is a semiconductor package comprising a substrate, a semiconductor element, and a bonding portion bonding the substrate and the semiconductor element, wherein the bonding portion is formed by using the above mentioned solder paste.

The semiconductor package is preferably a power semiconductor package.

Advantageous Effects of Invention

A solder alloy, a solder bonding material, a solder paste, and a semiconductor package of the present invention can suppress peeling of a solder bonding portion and a semiconductor element at the interface between them.

Brief Description of Drawings

Fig. 1 presents a schematic cross-sectional view showing a semiconductor package according to the present embodiment.
Fig. 2 presents a temperature profile showing reflow temperature conditions during preparation of a test bonded body used for each test according to Examples and Comparative Examples.
Fig. 3 presents one example of images obtained by photographing each test bonded body according to Examples and Comparative Examples by using an ultrasonic microscope, and Fig. 3(a) presents a bonding interface image (image A) photographed from the Si chip side and Fig. 3(b) presents a bonding interface image (image B) photographed from the substrate side.

Description of Embodiments

Here in below, one embodiment of a solder alloy, a solder bonding material, a solder paste, and a semiconductor package of the present invention are described in detail. The present invention is not limited to the following embodiments.

1. Solder alloy

A solder alloy of the present embodiment comprises 1.1% by mass or more and 8% by mass or less of Cu, 6% by mass or more and 20% by mass or less of Sb, 0.01% by mass or more and 0.5% by mass or less of Ni, and 0.001% by mass or more and 1% by mass or less of Co, and the balance being Sn.

The solder alloy of the present embodiment comprises Cu in an amount of 1.1% by mass or more and 8% by mass or less, thereby allowing precipitation of an intermetallic compound with Sn, Ni, Co in a solder bonding portion to be formed, such as a $Cu_6Sn_5$ intermetallic compound, a $(Cu,Ni)_6Sn_5$ intermetallic compound, a $(Cu,Co)_6Sn_5$ intermetallic compound, a $(Cu,Co,Ni)_6Sn_5$ intermetallic compound.

Of these intermetallic compounds, the $(Cu,Ni)_6Sn_5$ intermetallic compound, the $(Cu,Co)_6Sn_5$ intermetallic compound, and the $(Cu,Co,Ni)_6Sn_5$ intermetallic compound (hereinafter, these are collectively referred to as "Cu, Ni, Co-based intermetallic compounds") are easily precipitated at and near the interface between a semiconductor element and the solder bonding portion during solder bonding, and it is presumed that these intermetallic compounds can contribute to suppressing a peeling phenomenon at the interface between the semiconductor element and the solder bonding portion.

That is, as described above, the Ni film formed on a back electrode of the semiconductor element (in particular, a power semiconductor element) easily diffuses into the solder bonding portion due to a thermal load repeatedly received from the semiconductor element. The same applies to a Ni-Sn intermetallic compound precipitated by the Ni film and Sn included in the solder alloy during solder bonding between the semiconductor element and the substrate.

Depending on the type of the semiconductor element, a thin film composed of Ag or Au may be further formed on the Ni film. However, both Ag and Au are elements that easily diffuse into the solder bonding portion, thus making it difficult to suppress diffusion of the Ni film due to the presence of these thin films.

The Ni film contributes to bonding strength between the semiconductor element and the solder bonding portion. That is, a Ti film formed on a side closer to the semiconductor element than the Ni film is hard to precipitate an intermetallic compound with Sn included in the solder alloy. Therefore, the Ni film is formed in order to facilitate bonding between the semiconductor element and the solder bonding portion.

Therefore, as the Ni film and the Ni-Sn intermetallic compound further diffuse into the solder bonding portion, the bonding strength between the semiconductor element and the solder bonding portion further decreases. Finally, the peeling phenomenon may occur at the interface between the semiconductor element and the solder bonding portion.

The Ti film may be in an oxidized state ($TiO_2$ film) during solder bonding, depending on the production conditions of the semiconductor element. The $TiO_2$ film is harder to precipitate an intermetallic compound with Sn than the Ti film. Therefore, in this case, the peeling phenomenon is easier to occur.

However, the solder alloy of the present embodiment, as described above, can precipitate the Cu, Ni, Co-based intermetallic compounds in the solder bonding portion formed, in place of the Ni-Sn intermetallic compound. These intermetallic compounds are easily precipitated at and in the near the interface between the semiconductor element and the solder bonding portion during solder bonding, and have a fine structure. Therefore, diffusion of the Ni film into the solder bonding portion is presumed to be suppressed. This is presumed to allow suppressing the peeling phenomenon at the interface between the semiconductor element and the solder bonding portion.

In addition, the repetition of heat generation and cooling of the semiconductor element described above applies a repeated heat-cold load to the solder bonding portion in contact with the semiconductor element. This heat-cold load causes thermal fatigue and heat-cold fatigue of the solder bonding portion and causes stress in the solder bonding portion. This stress causes a crack in the solder bonding portion. In addition, the repeatedly generated stress promotes the progress of the generated crack, and finally causes peeling of the semiconductor element (due to this crack). This crack easily occurs when the power semiconductor, particularly, a next-generation power semiconductor element is used (for example, in a high-temperature operating environment of 200°C or more).

However, the solder alloy of the present embodiment precipitates the $Cu_6Sn_5$ intermetallic compound in the solder bonding portion as described above.

This intermetallic compound contributes to improvement of the strength of the solder bonding portion, and the solder alloy of the present embodiment can precipitate the intermetallic compound in the solder bonding portion in a well-balanced manner. Therefore, the solder alloy of the present embodiment can suppress the occurrence and progress of cracks in the solder bonding portion under a high-temperature operation environment, and can also suppress the occurrence of the peeling phenomenon of the semiconductor element caused thereby . As described above, the Cu, Ni, Co-based intermetallic compounds have a fine structure, and therefore can also contribute to the achievement of this effect.

As described above, a heat generation amount and a heat generation temperature of the next-generation power semiconductor element are higher than those of conventional power semiconductors. Therefore, diffusion of the Ni film or the like into the solder bonding portion described above easily occurs, and cracks in the solder bonding portion also more easily occur.

However, the solder alloy of the present embodiment can precipitate the Cu, Ni, Co-based intermetallic compounds and the $Cu_6Sn_5$ intermetallic compound in a well-balanced manner in the solder bonding portion formed as described above. Therefore, when the next-generation power semiconductor element is used, diffusion of the Ni film into the solder bonding portion and the peeling phenomenon at the interface between the next-generation power semiconductor element and the solder bonding portion due to this diffusion can be suppressed. In addition, occurrence of cracks in the solder bonding portion and the peeling phenomenon of the next-generation power semiconductor element due to progress of the cracks can also be suppressed.

The amount of Cu is preferably 1.5% by mass or more and 7% by mass or less, 2% by mass or more and 6.5% by mass or less. The amount of Cu is more preferably 3% by mass or more and 6% by mass or less, 3% by mass or more and 4% by mass or less. Setting the amount of Cu within any of these ranges can further contribute to the suppression of diffusion of the Ni film into the solder bonding portion and can further improve the strength of the solder bonding portion.

The solder alloy of the present embodiment comprises Sb in an amount of 6% by mass or more and 20% by mass or less, whereby the solid solution strengthening by Sb in the solder bonding portion can be improved, and a SbSn intermetallic compound (for example, a $Sb_2Sn_3$ intermetallic compound) can be precipitated in the solder bonding portion. This can improve the strength of the solder bonding portion and suppress the occurrence of cracks in the solder bonding portion described above, particularly the occurrence of cracks under the high-temperature operation environment, and the occurrence of peeling of the semiconductor element due to the progress of the cracks.

The amount of Sb is preferably 6% by mass or more and 15% by mass or less, 7% by mass or more and 15% by mass or less, 7% by mass or more and 14% by mass or less. The amount of Sb is more preferably 8% by mass or more and 13% by mass or less, 9% by mass or more and 12% by mass or less, 10% by mass or more and 11% by mass or less. Setting the amount of Sb within any of these ranges can further improve the solid solution strengthening by Sb described above in the solder bonding portion, can precipitate the intermetallic compounds in a well-balanced manner, and can further improve the strength of the solder bonding portion.

The solder alloy of the present embodiment comprises Ni in an amount of 0.01% by mass or more and 0.5% by mass or less, whereby intermetallic compounds with Sn, Cu, and Co, for example, the $(Cu, Ni)_6Sn_5$ intermetallic compound and the $(Cu,Co,Ni)_6Sn_5$ intermetallic compound can be precipitated in the solder bonding portion as described above. These intermetallic compounds are presumed to allow contributing to the suppression of the peeling phenomenon at the interface between the semiconductor element and the solder bonding portion as described above. In addition, these intermetallic compounds have a fine structure, and therefore can also contribute to the effect of suppressing the progress of cracks generated in the solder bonding portion.

The amount of Ni is preferably 0.02% by mass or more and 0.4% by mass or less, 0.025% by mass or more and 0.35% by mass or less, 0.03% by mass or more and 0.3% by mass or less. The amount of Ni is more preferably 0.035% by mass or more and 0.2% by mass or less. Setting the amount of Ni within any of these ranges can further suppress diffusion of the Ni film into the solder bonding portion described above.

The solder alloy of the present embodiment comprises Co in an amount of 0.001% by mass or more and 1% by mass or less, whereby intermetallic compounds with Sn, Ni, and Cu, for example, the $(Cu, Co)_6Sn_5$ intermetallic compound and the $(Cu,Co,Ni)_6Sn_5$ intermetallic compound can be precipitated in the solder bonding portion as described above.

These intermetallic compounds are presumed to allow contributing to the suppression of the peeling phenomenon at the interface between the semiconductor element and the solder bonding portion as described above. In addition, these intermetallic compounds have a fine structure, and therefore can also contribute to the effect of suppressing the progress of cracks generated in the solder bonding portion.

The amount of Co is preferably 0.002% by mass or more and 0.9% by mass or less, 0.003% by mass or more and 0.8% by mass or less, 0.004% by mass or more and 0.8% by mass or less. The amount of Co is more preferably 0.005% by mass or more and 0.6% by mass or less. The amount of Co is particularly preferably 0.006% by mass or more and 0.5% by mass or less, 0.007% by mass or more and 0.4% by mass or less, 0.007% by mass or more and 0.3% by mass or less. Setting the amount of Co within any of these ranges can further suppress diffusion of the Ni film into the solder bonding portion.

As described above, the solder alloy of the present embodiment can precipitate the Cu, Ni, Co-based intermetallic compounds in the solder bonding portion by adding predetermined amounts of Cu, Ni, and Co to the solder alloy including Sn.

It is presumed that the suppression of diffusion of the Ni film described above into the solder bonding portion can be achieved by the precipitation of these intermetallic compounds and the balance thereof.

In addition, these intermetallic compounds have a fine structure. Therefore, the precipitation balance of these intermetallic compounds is presumed to allow suppressing the progress of the crack even when the crack occurs in the solder bonding portion.

In addition, the solder alloy of the present embodiment can precipitate the $Cu_6Sn_5$ intermetallic compound and the SbSn intermetallic compound as intermetallic compounds of Sn, Cu, and Sb in the solder bonding portion by adding predetermined amounts of Cu and Sb to the solder alloy including Sn.

It is presumed that the crack generation suppressing effect of the solder bonding portion described above can be achieved by the precipitation of these intermetallic compounds and the balance thereof.

As described above, the solder alloy of the present embodiment can achieve the suppression of the peeling phenomenon at the interface between the semiconductor element and the solder bonding portion, and the suppression of the peeling phenomenon of the semiconductor element due to the crack generated in the solder bonding portion and the progress of the crack.

In addition, in the solder alloy of the present embodiment, the solder bonding portion has good strength as described above, and therefore can also suppress the occurrence of cracks in the semiconductor element itself due to the stress generated at the interface between the solder bonding portion and the semiconductor element.

Therefore, the solder alloy of the present embodiment can be suitably used for bonding a semiconductor element, particularly a power semiconductor element including a next-generation power semiconductor element, and a substrate.

The solder alloy of the present embodiment can also be suitably used for applications other than bonding between the semiconductor element and the substrate, that is, for (solder) bonding between bonded materials. Examples of the applications include bonding between a substrate in a semiconductor package and a heat dissipation substrate, bonding between a substrate (an electronic circuit board) and an electronic component (in particular, an electronic component having high heat resistance), and the like.

In addition, the amount of Cu (% by mass) and the amount of Ni (% by mass) in the solder alloy of the present embodiment preferably satisfy the following formula (A).

$$\text{The amount of Ni}/(\text{the amount of Cu} + \text{the amount of Ni}) < 0.10 \quad \dots \quad (A)$$

When the solder alloy of the present embodiment comprises Cu and Ni in this range, diffusion of the Ni film into the solder bonding portion can be further suppressed. In this case, the effect of suppressing the crack generated in the solder bonding portion and the peeling of the semiconductor element due to the progress of the crack occurred can be further improved.

The amount of Cu (% by mass) and the amount of Ni (% by mass) in the solder alloy of the present embodiment more preferably satisfy the following formula (A').

$$0.03 < \text{the amount of Ni}/(\text{the amount of Cu} + \text{the}$$

$$\text{amount of Ni}) < 0.09... \quad (A')$$

The above formulas (A) and (A') are calculated by rounding off to the second decimal place.

In addition, the solder alloy of the present embodiment can further comprise Ag in an amount of 0.1% by mass or more and less than 3% by mass. In this case, an $Ag_3Sn$ intermetallic compound can be precipitated in the solder bonding portion, and the residual stress in the solder bonding portion can be reduced. Thus, the mechanical strength of the solder bonding portion can be improved.

When such a solder alloy is used for a solder paste, a void generation suppressing effect can be improved.

The amount of Ag is preferably 0.2% by mass or more and 2.9% by mass or less, 0.2% by mass or more and 2.5% by mass or less, 0.2% by mass or more and 2% by mass or less. The amount of Ag is more preferably 0.5% by mass or more and 1.5% by mass or less. Setting the amount of Ag within any of these ranges can further improve the mechanical strength of the solder bonding portion.

In addition, the solder alloy of the present embodiment can further comprise at least one of Al, Ti, Si, Fe, and Ge, that is, one element or a plurality of these elements. In this case, the strength of the solder bonding portion can be further improved.

The total amount of at least one of Al, Ti, Si, Fe, and Ge is preferably 0.003% by mass or more and 0.5% by mass or less, and more preferably 0.005% by mass or more and 0.3% by mass or less. Setting the total amount within any of these ranges can further improve the strength of the solder bonding portion.

The balance of the solder alloy of the present embodiment is Sn. The solder alloy naturally comprises inevitable impurities.

2. Solder bonding material

A solder bonding material of the present embodiment uses the solder alloy of the above embodiment, and examples thereof include the following.

- Solder preform

A solder preform may have any shape as long as it is sheet-like. For example, a disk shape, a corner shape, a tape shape, or the like can be used. In the production of the solder preform, for example, a known production method can be used such as a method of rolling an ingot composed of the solder alloy of the above embodiment by using a rolling mill.

The shape, size, and thickness of the solder preform can be appropriately adjusted depending on the type of the substrate, semiconductor element, or the like to be used. The thickness is preferably 10 $\mu$m or more and 500 $\mu$m or less, and more preferably 30 $\mu$m or more and 300 $\mu$m or less.

In addition, the solder bonding can be performed by applying a flux described later to the surface of the solder preform. In addition, solder bonding can be performed by preliminarily flux-coating the surface of the solder preform with an organic acid or the like. Furthermore, the solder preform can also be subjected to solder bonding by using, for example, formic acid reflow or hydrogen reflow and the like in a reducing atmosphere.

- Bonding material having solder bonding layer

Examples of a bonding material having a solder bonding layer comprise bonding materials having the following structures.

That is, the bonding material having the solder bonding layer have, for example, a reinforcing layer and a solder layer. This solder layer is laminated on the upper surface and the lower surface of the reinforcing layer by using a hot rolling method or the like. The solder layer is formed by using the solder alloy of the above embodiment.

In addition, the reinforcing layer has a core substrate. This core substrate is composed of, for example, CuMo, Mo, or the like. A metal layer may be provided on both surfaces of the core substrate if necessary. This metal layer may be, for example, a layer composed of at least one of Ni, Sn, Cu, Au, and Ag, a layer having an intermetallic compound derived from these alloy elements, or a combination thereof. The metal layer is formed, for example, by plating.

- Solder paste

A solder paste of the present embodiment is described in detail in the following section 3.

In addition to the solder preform and the solder paste described later, the solder bonding material of the present embodiment may have any form as long as it can be used for bonding a semiconductor element and a substrate, particularly for bonding a power semiconductor element and a substrate.

The solder bonding material of the present embodiment uses the solder alloy of the above embodiment, and therefore diffusion of the Ni film into the solder bonding portion can be suppressed, and generation and progress of cracks in the solder bonding portion can be suppressed. Therefore, the solder bonding material of the present embodiment can suppress the occurrences of both the peeling phenomenon at the interface between the semiconductor element and the solder bonding portion, and the peeling phenomenon of the semiconductor element caused by the progress of cracks in the solder bonding portion.

In addition, in the solder bonding material of the present embodiment, the solder bonding portion has good strength, and therefore it is also possible to suppress the occurrence of cracks in the semiconductor element itself due to stress generated at the interface between the solder bonding portion and the semiconductor element.

Therefore, the solder bonding material of the present embodiment can be suitably used for bonding a semiconductor element, particularly a power semiconductor element including a next-generation power semiconductor element, with a substrate.

The solder bonding material of the present embodiment can also be suitably used for applications other than bonding between the semiconductor element and the substrate, that is, for (solder) bonding between bonded materials. Examples of the applications include bonding between a substrate in a semiconductor package and a heat dissipation substrate, bonding between a substrate (electronic circuit board) and an electronic component (in particular, an electronic component having high heat resistance), and the like.

3. Solder paste

A solder paste of the present embodiment is produced, for example, by kneading a powdery solder alloy of the above embodiment (a powder composed of a solder alloy) and a flux to form a paste.

The powder composed of the solder alloy is obtained by forming the solder alloy of the above embodiment into a powder form by a known method. The particle size (measured by a dynamic light scattering method) of the powder composed of the solder alloy can be, for example, 1 $\mu$m or more and 40 $\mu$m or less. In addition, the particle size may be 5 $\mu$m or more and 35 $\mu$m or less, 10 $\mu$m or more and 30 $\mu$m or less.

As the flux, for example, a flux comprising a resin, a thixotropic agent, an activator, and a solvent is used.

Examples of the resin include rosin resins; acrylic resins obtained by polymerizing at least one monomer of acrylic acid, methacrylic acid, various esters of acrylic acid, various esters of methacrylic acid, crotonic acid, itaconic acid, maleic acid, maleic anhydride, esters of maleic acid, esters of maleic anhydride, acrylonitrile, methacrylonitrile, acrylamide, methacrylamide, vinyl chloride, vinyl acetate, and the like; epoxy resins; phenol resins and the like. These can be used singly or in combination of two or more.

Examples of the rosin resin include rosins such as tall oil rosin, gum rosin, and wood rosin; rosin-modified resins such as hydrogenated rosin (partial hydrogenation and complete hydrogenation), polymerized rosin, heterogenized rosin, acrylic acid-modified rosin, maleic acid-modified rosin, and formylated rosin; and derivatives thereof. These can be used singly or in combination of two or more.

An acid value of the resin can be, for example, 10 mgKOH/g or more and 250 mgKOH/g or less. The amount of the resin can be, for example, 10% by mass or more and 90% by mass or less with respect to the total amount of the flux.

Examples of the thixotropic agent include hardened castor oil, a bisamide-based thixotropic agent (saturated fatty acid bisamide, unsaturated fatty acid bisamide, aromatic bisamide, and the like), and dimethyldibenzylidene sorbitol. These can be used singly or in combination of two or more. The amount of the thixotropic agent can be, for example, 3% by mass or more and 15% by mass or less with respect to the total amount of the flux.

Examples of the activator include organic acids, halogen-containing compounds, and amine-based activators. These can be used singly or in combination of two or more.

Examples of the organic acid include monocarboxylic acids, dicarboxylic acids, and other organic acids.

Examples of the monocarboxylic acid include propionic acid, butyric acid, valeric acid, caproic acid, enanthic acid, capric acid, lauric acid, myristic acid, pentadecylic acid, palmitic acid, margaric acid, stearic acid, tuberculostearic acid, arachidic acid, behenic acid, lignoceric acid, and glycolic acid, and the like.

Examples of the dicarboxylic acid include oxalic acid, malonic acid, succinic acid, glutaric acid, adipic acid, pimelic acid, suberic acid, azelaic acid, sebacic acid, dodecanedioic acid, eicosanedioic acid, fumaric acid, maleic acid, tartaric acid, diglycolic acid, and 1,4-cyclohexanedicarboxylic acid, and the like.

Examples of other organic acids include dimer acid, levulinic acid, lactic acid, acrylic acid, benzoic acid, salicylic acid, anisic acid, citric acid, picolinic acid, and anthranilic acid, and the like.

Examples of the halogen-containing compound include an undissociated halogen compound (an undissociated activator) and a dissociated halogen compound (a dissociated activator).

Examples of the undissociated activator include non-salt organic compounds in which a halogen atom is bonded by a covalent bond. The organic compound may be, for example, a compound in which individual elements of chlorine, bromine, iodine, and fluorine are covalently bonded, such as chloride, bromide, iodide, and fluoride, or a compound in which two or more different halogen atoms are covalently bonded. In addition, the organic compound preferably has a polar group such as a hydroxyl group, for example, in a halogenated alcohol, in order to improve solubility in an aqueous solvent.

Examples of the amine-based activator include amines, amine salts, amino acids, and amide-based compounds, and the like.

The amount of the activator can be 5% by mass or more and 15% by mass or less with respect to the total amount of the flux. The amount of the activator may be 70 by mass or more and 13% by mass or less, or 9% by mass or more and 11% by mass or less with respect to the total amount of the flux.

Examples of the solvent include alcohol-based, butyl cellosolve-based, glycol ether-based, and ester-based solvents, and the like. These can be used singly or in combination of two or more.

The amount of the solvent can be 20% by mass or more and 50% by mass or less with respect to the total amount of the flux. The amount of the solvent may be 20% by mass or more and 40% by mass or less, or 35% by mass or more and 40% by mass or less with respect to the total amount of the flux.

An antioxidant can be comprised in the flux. Examples of the antioxidant include hindered phenol-based antioxidants, phenol-based antioxidants, bisphenol-based antioxidants, and polymer-type antioxidants. Of these, the hindered phenol-based antioxidant is particularly preferably used.

The type of the antioxidant is not limited thereto, and the amount thereof is also not particularly limited. The general amount is about 0.5% by mass to 5% by mass with respect to the total amount of the flux.

Additives such as a matting agent and an antifoaming agent may be further added to the flux. The amount of the additive can be 10% by mass or less and also 5% by mass or less with respect to the total amount of the flux.

When the solder paste of the present embodiment is produced, the ratio (% by mass) between the powder composed of the solder alloy and the flux can be 65 : 35 to 95 : 5 in terms of the ratio of the powder composed of the solder alloy to the flux. In addition, for example, the ratio can be set to 85 : 15 to 93 : 7 or 87 : 13 to 92 : 8.

When the semiconductor element and the substrate are bonded by using the solder paste of the present embodiment, it is possible to suppress the occurrences of both the peeling phenomenon at the interface between the semiconductor element and the solder bonding portion described above, and the peeling phenomenon of the semiconductor element caused by the occurrence and the progress of cracks in the solder bonding portion. In addition, the solder paste of the present embodiment can suppress generation of voids in the solder bonding portion, and therefore it is possible to provide a more reliable solder bonding portion.

As described above, the solder paste of the present embodiment can also be suitably used for applications other than bonding of a semiconductor element and a substrate.

- Semiconductor package

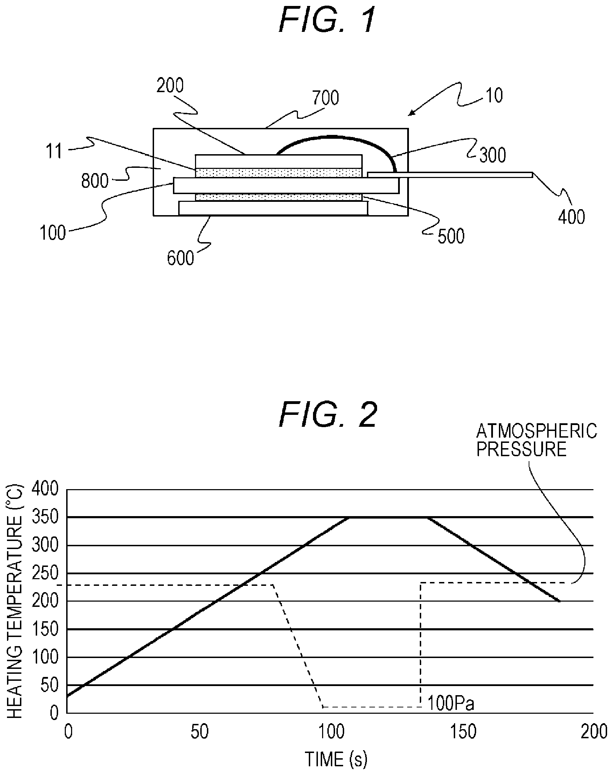

An example of a semiconductor package produced by using the solder alloy, the solder bonding material, and the solder paste of the present embodiment are described with reference to Fig. 1.

A semiconductor package 10 comprises a substrate 100, a bonding portion 11, a semiconductor element 200, a wire 300, a lead frame 400, a solder portion 500, a Cu base substrate 600, a housing 700, and a molding resin 800. A Ti film and a Ni film are formed on a back electrode of the semiconductor element 200 in this order from the semiconductor element 200 side (not illustrated).

The bonding portion 11 is formed by using the solder bonding material (including the solder paste) of the present embodiment. The bonding portion 11 bonds the substrate 100 and the semiconductor element 200, and is sandwiched between the substrate 100 and the semiconductor element 200.

As the substrate 100, for example, a Cu substrate, a direct bonded copper (DBC) substrate having Cu layers on both surfaces, or a direct bonded aluminum (DBA) substrate having Al layers on both surfaces is preferably used.

The type of the semiconductor element 200 is not particularly limited. As the semiconductor element 200, a power semiconductor element (for example, a chip-shaped Si element) or a next-generation power semiconductor element may be used.

The wire 300 electrically connects an electrode (not illustrated) formed on the surface of the semiconductor element 200 and the lead frame 400.

The solder portion 500 bonds the Cu base substrate 600 and the substrate 100. The solder portion 500 can also be formed by using the solder bonding material of the present embodiment.

The Cu base substrate 600 is heat-dissipative and serves as a heat dissipation substrate.

The semiconductor package 10 is covered with the housing 700, and is filled with the molding resin 800.

The semiconductor package 10 is produced, for example, by the following method.

That is, the solder bonding material of the present embodiment is placed (applied in the case of the solder paste) on the substrate 100, the semiconductor element 200 is arranged thereon, and these are bonded by using a reflow device while a predetermined load is applied thereto. Thereafter, the semiconductor element 200 and the lead frame 400 are bonded by using the wire 300. Then, the substrate 100 on which the semiconductor element 200 is mounted and the Cu base substrate 600 are solder-bonded and covered with the housing 700. Thereafter, the semiconductor package 10 is produced by filling the inside with the molding resin 800 and curing the molding resin.

As described above, the bonding portion 11 in the semiconductor package 10 is formed by using the solder bonding material of the above embodiment. Therefore, when a high temperature is loaded on the bonding portion 11, diffusion of the Ni film of the semiconductor element 200 into the bonding portion 11 can be suppressed. In addition, the bonding portion 11 has appropriate strength, and therefore the occurrence of cracks inside the bonding portion can be suppressed.

Therefore, the bonding portion 11 can suppress both the peeling phenomena, that is, the occurrence of the peeling at the interface with the semiconductor element 200, and the occurrence of the peeling of the semiconductor element 200 caused by the occurrence and the progress of cracks in the bonding portion 11.

In addition, when the bonding portion 11 is formed by using the solder paste of the embodiment described above, generation of voids in the bonding portion 11 can be suppressed, and therefore the bonding portion 11 with higher reliability can be obtained.

In addition, when the solder portion 500 is formed by using the solder bonding material of the above embodiment, the solder portion 500 has appropriate strength, and thus can suppress the occurrence of cracks inside the solder portion. Therefore, the solder portion 500 can efficiently dissipate the heat (derived from the heat generation of the semiconductor element 200) transferred from the substrate 100 to the Cu substrate 600 for a long time and in an efficient manner, and the reliability of the semiconductor package 10 can be further improved.

In addition, when the solder portion 500 is formed by using the solder paste of the above embodiment, generation of voids in the solder portion 500 can be suppressed, and thus the above heat dissipation can be further improved.

The same applies to the case where the semiconductor package 10 is a power semiconductor package.

The semiconductor package 10 is not limited to the above embodiment, and various modifications can be made as long as they do not impair the effects.

- Method for bonding substrate and semiconductor element

As described above, the solder alloy described above can be used in a method for bonding a substrate and a semiconductor element. That is, the present embodiment includes the following method for using a solder alloy:
Use of a solder alloy for bonding a substrate and a semiconductor element, wherein the solder alloy comprises Cu in an amount of 1.1% by mass or more and 8% by mass or less, Sb in an amount of 6% by mass or more and 20% by mass or less, Ni in an amount of 0.01% by mass or more and 0.5% by mass or less, and Co in an amount of 0.001% by mass or more and 1% by mass or less, and the balance being Sn.

Furthermore, the solder bonding material (including the solder paste) described above can be used for a method for bonding a substrate and a semiconductor element.

Examples

Hereinafter, the present invention is described in detail with reference to Examples and Comparative Examples. The present invention is not limited to these Examples.

A. Solder preform

Each solder preform (6 mm × 6 mm, thickness 60 μm) was produced by using each solder alloy described in Table 1.

The value of Ni/(Cu + Ni) of each solder alloy described in Table 1 was calculated by rounding off the value to the second decimal place according to the following formula.

$$\text{An amount of Ni (\% by mass)/(an amount of Cu (\% by mass) + an amount of Ni (\% by mass))}$$

[Table 1]

|  | Sn | Cu | Sb | Ni | Co | Ag | Others | Ni/(Cu+Ni) |
|---|---|---|---|---|---|---|---|---|
| Example 1 | Balance | 1.1 | 10 | 0.01 | 0.004 |  |  | 0.01 |
| Example 2 | Balance | 1.1 | 10 | 0.02 | 0.004 |  |  | 0.02 |
| Example 3 | Balance | 1.1 | 10 | 0.02 | 0.004 | 0.1 |  | 0.02 |
| Example 4 | Balance | 1.1 | 10 | 0.02 | 0.004 | 1.5 |  | 0.02 |
| Example 5 | Balance | 1.1 | 10 | 0.035 | 0.001 | 2.9 |  | 0.03 |
| Example 6 | Balance | 3 | 10 | 0.2 | 0.004 | 0.1 |  | 0.06 |
| Example 7 | Balance | 5 | 10 | 0.4 | 0.004 | 0.1 |  | 0.07 |
| Example 8 | Balance | 8 | 10 | 0.4 | 0.007 | 0.1 |  | 0.05 |
| Example 9 | Balance | 8 | 10 | 0.5 | 0.007 | 0.1 |  | 0.06 |
| Example 10 | Balance | 3 | 10 | 0.2 | 0.001 | 0.1 |  | 0.06 |
| Example 11 | Balance | 3 | 10 | 0.2 | 0.1 | 0.1 |  | 0.06 |
| Example 12 | Balance | 3 | 10 | 0.2 | 0.2 | 0.1 |  | 0.06 |
| Example 13 | Balance | 3 | 10 | 0.2 | 0.3 | 0.1 |  | 0.06 |
| Example 14 | Balance | 3 | 10 | 0.2 | 1 | 0.1 |  | 0.06 |
| Example 15 | Balance | 5 | 6 | 0.2 | 0.005 | 0.1 |  | 0.04 |
| Example 16 | Balance | 5 | 15 | 0.2 | 0.005 | 0.1 |  | 0.04 |
| Example 17 | Balance | 5 | 20 | 0.2 | 0.005 | 0.1 |  | 0.04 |
| Example 18 | Balance | 3 | 10 | 0.2 | 0.004 | 0.1 | Al:0.05 | 0.06 |
| Example 19 | Balance | 3 | 10 | 0.2 | 0.004 | 0.1 | Ti:0.05 | 0.06 |
| Example 20 | Balance | 3 | 10 | 0.2 | 0.004 | 0.1 | Si:0.05 | 0.06 |
| Example 21 | Balance | 3 | 10 | 0.2 | 0.004 | 0.1 | Fe:0.05 | 0.06 |
| Example 22 | Balance | 3 | 10 | 0.2 | 0.004 | 0.1 | Ge:0.05 | 0.06 |
| Example 23 | Balance | 1.1 | 10 | 0.15 | 0.004 |  |  | 0.12 |
| Comparative Example 1 | Balance | 0.5 |  |  |  | 3.0 |  | - |
| Comparative Example 2 | Balance |  | 5 |  |  |  |  | - |
| Comparative Example 3 | Balance |  | 10 |  |  |  |  | - |
| Comparative Example 4 | Balance | 1.1 | 10 | 0.02 | 0.004 | 3.0 |  | 0.02 |
| Comparative Example 5 | Balance | 1.1 | 10 | 0.02 | 0.004 | 5.0 |  | 0.02 |
| Comparative Example 6 | Balance | 0.8 | 10 | 0.2 | 0.004 |  |  | 0.20 |
| Comparative Example 7 | Balance | 1 | 10 | 0.2 | 0.004 |  |  | 0.17 |
| Comparative Example 8 | Balance | 9 | 10 | 0.2 | 0.004 |  |  | 0.02 |
| Comparative Example 9 | Balance | 1.1 | 10 | 0.02 |  |  |  | 0.02 |
| Comparative Example 10 | Balance | 1.1 | 10 | 0.05 | 1.1 |  |  | 0.04 |
| Comparative Example 11 | Balance | 5 | 5 | 0.2 | 0.004 |  |  | 0.04 |
| Comparative Example 12 | Balance | 5 | 21 | 0.2 | 0.004 |  |  | 0.04 |

(1) Ni thinning inhibition confirmation test

The following tools were prepared.

- Si chip (size: 5 mm□, thickness: 0.3 mm, Ti film formation (0.1 $\mu$m) and Ni film formation (0.5 $\mu$m) sequentially laminated on the bonding surface side)
- Substrate (electrolytic Ni plated Cu plate, size: 20 mm□, thickness: 1 mm, thickness of Ni plating: 5 $\mu$m)

Each solder preform applied with a flux (product name: EC-19S-8, manufactured by TAMURA Corporation) and dried was placed on the substrate (central portion). Then, the Si chip was placed on each solder preform (central portion).

Then, these were reflowed under the following conditions to produce each test bonded body having the substrate, the Si chip, and the bonding portion for bonding them.

- Reflow conditions

Under the mount load condition of 30 g, reflow was performed by using a reflow apparatus (product name: SMT Scope SK-5000, manufactured by Sanyo Seiko Corporation) based on the temperature profile condition (peak temperature: 350°C) shown in Fig. 2.

In the reflow, heating was started in an atmosphere with an oxygen concentration of 100 ppm and under the atmospheric pressure, and vacuuming was started when the reflow temperature reached 240°C, and the pressure in the reflow apparatus was reduced to 100 Pa and maintained. Then, after the reflow temperature reached 350°C, the pressure reduction was released after the temperature was maintained for 30 seconds, and the pressure in the reflow apparatus was returned to the atmospheric pressure to perform cooling. The change in pressure in the reflow apparatus with the temperature profile (indicated by the dotted line) is also shown in Fig. 2.

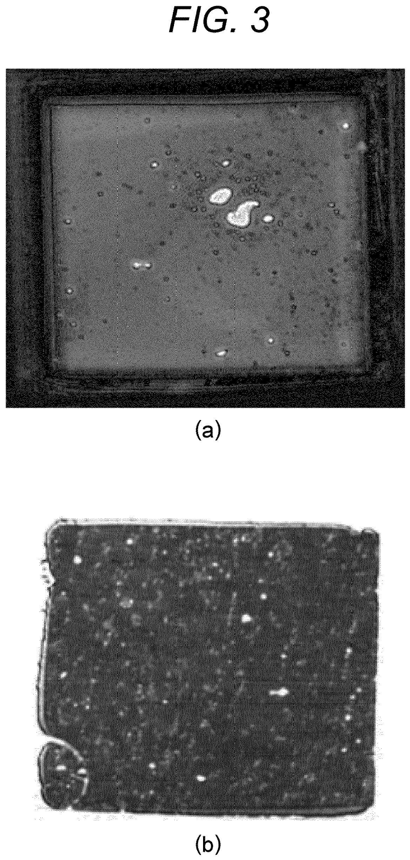

Then, for each test bonded body, a bonding interface image (refer to image A in Fig. 3(a)) photographed from the Si chip side was acquired by using an ultrasonic microscope (product name: C-SAM Gen6, manufactured by Nordson Advanced Technology).

Then, in region A in which the Si chip and the bonding portion appeared to overlap each other on image A, the area (area X) of the region where the Si chip and the bonding portion were bonded to each other was calculated by the following method.

That is, the area (area Y) of region A and the area (area Z) of the non-bonding portion (portion showing white in region A shown in Fig. 3(a)) in region A were calculated, and the value obtained by subtracting area Z from area Y was taken as area X.

Then, a value obtained by dividing the calculated area X by area Y was defined as bonding ratio 1.

Then, each test bonded body was heated at 210°C for 500 hours by using a blower constant temperature thermostat (product name: DKN402, manufactured by Yamato Scientific Co., Ltd.). Then, for each test bonded body after heating, the bonding ratio (bonding ratio 2) was calculated in the same manner as described above.

The difference between bonding ratio 1 and bonding ratio 2, that is, the increase ratio of the non-bonding portion was evaluated as the Ni thinning inhibition ratio based on the following criteria. The results are shown in Table 2.

     O: The Ni thinning inhibition ratio is less than 5%.
     O: Ni thinning inhibition ratio is 5% or more and less than 10%.
     △: Ni thinning inhibition ratio is 10% or more and less than 20%.
     ×: Ni thinning inhibition ratio is 20% or more.

(2) Peeling confirmation test

Each test bonded body was produced in the same manner as in (1) Ni thinning inhibition confirmation test described above. Then, for each test bonded body, a bonding interface image (refer to image A in Fig. 3(a)) photographed from the Si chip side and a bonding interface image (refer to image B in Fig. 3(b)) photographed from the substrate side were acquired by using an ultrasonic microscope (product name: C-SAM Gen6, manufactured by Nordson Advanced Technology Inc.).

Then, the following method calculated the total value (area X') of the area of the region where the Si chip and the bonding portion were bonded in region A where the Si chip and the bonding portion appeared to overlap each other on image A, and the area of the region where the bonding portion and the substrate were bonded in region B where the bonding portion and the substrate appeared to overlap each other on image B.

That is, the total value (area Y') of the area of region A and the area of region B and the total value (area Z') of the areas of the non-bonding portions (portions showing white in region A in Fig. 3(a) and region B in Fig. 3(b)) in region A and region B were calculated, and a value obtained by subtracting area Z' from area Y' was set as area X'.

Then, a value obtained by dividing the calculated area X' by area Y' was defined as bonding ratio 1'.

Then, using a thermal shock testing apparatus (product name: ES-76LMS, manufactured by Hitachi Appliances, Ltd.) set at -40°C (15 minutes) to 200°C (15 minutes), each test bonded body was exposed to an environment in which 500 cycles of thermal shock cycles were repeated, and then taken out. The bonding ratio (bonding ratio 2') of each test bonded body after the thermal shock cycle was calculated in the same manner as described above.

The difference between bonding ratio 1' and bonding ratio 2', that is, an increase ratio of the non-bonding portion was defined as a peeling ratio, and evaluation was performed based on the following criteria. The results are shown in Table 2.

○: Peeling ratio is less than 10%.
△: Peeling ratio is 10% or more and less than 20%.
×: Peeling ratio is 20% or more.

(3) Si chip crack confirmation test

The surface of each test bonded body after being subjected to the thermal shock cycle in (2) peeling confirmation test was observed by using an ultrasonic microscope (product name: C-SAM Gen6, manufactured by Nordson Advanced Technology Inc.) to confirm whether a crack was generated in the Si chip. The results (presence or absence of cracks) are shown in Table 2.

○: No crack
×: There is a crack.

B. Solder paste

The following components were adjusted to obtain a flux.

Resin: 50% by mass of KE-604 (acrylic modified hydrogenated rosin, manufactured by Arakawa Chemical Industries, Ltd.)
Activator: 2% by mass of suberic acid, 0.5% by mass of malonic acid, and 1% by mass of dibromobutenediol
Solvent: 38.5% by mass of diethylene glycol monohexyl ether (DEH)
Thixotropic agent: 5% by mass of Himakou (12-hydroxystearic acid triglyceride, manufactured by KF trading Co., Ltd.)
Additive: 3% by mass of IRGANOX 245 (hindered phenol antioxidant, manufactured by BASF Japan Ltd.)

To produce solder pastes according to Examples and Comparative Examples, 11.0% by mass of the flux and 89.0% by mass of powder of each solder alloy described in Table 1 (powder particle size: 20 $\mu$m to 38 $\mu$m) were mixed.

(4) Void confirmation test

The same tools as those used in (1) Ni thinning inhibition confirmation test and a metal mask (opening portion: 3.5 mm × 3.5 mm, thickness: 0.2 mm) were prepared.

Each solder paste was printed on a substrate (central portion) by using the metal mask. Then, the Si chip was placed on the surface (center) of each solder paste printed.

These were reflowed under the same conditions as in (1) Ni thinning inhibition confirmation test to produce each test bonded body having the substrate, the Si chip, and a bonding portion for bonding them.

Then, the surface state of each test body described above was observed from the upper surface (the Si chip side) with an X-ray inspection apparatus (product name: XD7600NT Diamond, manufactured by Nordson Corporation), and the area of the region where the Si chip and the bonding portion of each test bonded body overlap and the area of the void generated in the bonding portion were measured.

Then, for each of the test bonded bodies, the void area ratio was calculated based on the following formula. The results are shown in Table 2.

Total area of void generated in bonding portion/Area of region where Si chip and bonding portion overlap × 100 (%)

In this example, when the void area ratio is 50 or more, the evaluation is determined as ×.

[Table 2]

| | (1) Ni thinning inhibition confirmation test | (2) Peeling confirmation test | (3) Si chip crack confirmation test | (4) Void confirmation test |
|---|---|---|---|---|
| Example 1 | △ | ○ | ○ | 0.7 |
| Example 2 | △ | ○ | ○ | 0.8 |
| Example 3 | △ | ○ | ○ | 0.5 |
| Example 4 | △ | ○ | ○ | 0.4 |
| Example 5 | ○ | △ | ○ | 1.1 |
| Example 6 | ○ | ○ | ○ | 1.4 |
| Example 7 | ⊙ | ○ | ○ | 1.2 |
| Example 8 | ⊙ | △ | ○ | 2.3 |
| Example 9 | ⊙ | △ | ○ | 2.5 |
| Example 10 | △ | ○ | ○ | 0.4 |
| Example 11 | ○ | ○ | ○ | 1.5 |
| Example 12 | ⊙ | ○ | ○ | 2.4 |
| Example 13 | ⊙ | ○ | ○ | 3.2 |
| Example 14 | ⊙ | △ | ○ | 3.7 |
| Example 15 | ⊙ | △ | ○ | 0.4 |
| Example 16 | ○ | ○ | ○ | 3.2 |
| Example 17 | △ | △ | ○ | 4.7 |
| Example 18 | ⊙ | ○ | ○ | 3.2 |
| Example 19 | ⊙ | ○ | ○ | 2.7 |
| Example 20 | ⊙ | ○ | ○ | 2.6 |
| Example 21 | ⊙ | ○ | ○ | 3.8 |
| Example 22 | ⊙ | ○ | ○ | 3.2 |
| Example 23 | △ | △ | ○ | 2.1 |
| Comparative Example 1 | × | × | ○ | 1.2 |
| Comparative Example 2 | × | × | ○ | 0.6 |
| Comparative Example 3 | × | △ | ○ | 1.5 |
| Comparative Example 4 | ○ | × | ○ | 2.5 |
| Comparative Example 5 | ○ | × | × | 3.4 |
| Comparative Example 6 | × | | ○ | 1.4 |
| Comparative Example 7 | × | | ○ | 1.2 |
| Comparative Example 8 | ○ | × | × | 6.8 |

(continued)

| | (1) Ni thinning inhibition confirmation test | (2) Peeling confirmation test | (3) Si chip crack confirmation test | (4) Void confirmation test |
|---|---|---|---|---|
| Comparative Example 9 | × | ○ | ○ | 0.7 |
| Comparative Example 10 | ○ | × | × | 5.6 |
| Comparative Example 11 | ○ | × | ○ | 0.5 |
| Comparative Example 12 | × | △ | × | 7.8 |

From the above results, it can be seen that the bonding portion formed by using the solder preform according to Example can suppress diffusion of the Ni film of the Si chip into the bonding portion when a high temperature is loaded. In addition, such a bonding portion has good strength, and therefore it can be seen that the occurrence of cracks inside the bonding portion can be suppressed.

Therefore, it can be seen that the solder preform according to Examples can suppress the occurrence of both the peeling phenomena, that is, the peeling at the interface between the Si chip and the bonding portion and the occurrence of the peeling of the Si chip caused by the occurrence and the progress of cracks in bonding portion.

In addition, it can be seen that the solder paste of the present Examples can suppress generation of voids in the bonding portion formed with the solder paste, and therefore a more reliable bonding portion can be provided.

In the case of the solder preform and the solder paste of Comparative Examples using the solder alloy comprising Cu, Sb, Ni, Co, and Sn but the amount of each alloy element is outside the predetermined ranges, it can be seen that at least one of the above test results is ×.

Therefore, the solder alloy, the solder bonding body, and the solder paste of the present invention are suitably used for semiconductor packages, particularly power semiconductor packages.

In the present Examples, each test was performed by using a Si chip as a semiconductor element. However, each of the above test conditions demonstrated favorable results although a high heat of 200°C was applied to the test bonded body comprising the Si chip. Therefore, from these results, it is clear that the same effects can be exhibited when a next-generation power semiconductor element is used instead of the Si chips in Examples.

Reference Signs List

10      Semiconductor package
100     Substrate
200     Semiconductor element
300     Wire
400     Lead frame
500     Solder portion
600     Cu base substrate
700     Housing
800     Molding resin

**Claims**

1.  A solder alloy comprising 1.1% by mass or more and 8% by mass or less of Cu, 6% by mass or more and 20% by mass or less of Sb, 0.01% by mass or more and 0.5% by mass or less of Ni, and 0.001% by mass or more and 1% by mass or less of Co, and the balance being Sn.

2.  The solder alloy according to claim 1, wherein an amount of Cu (% by mass) and an amount of Ni (% by mass) satisfying following formula (A):

```
The amount of Ni/(the amount of Cu + the amount of

Ni) < 0.10...  (A).
```

3. The solder alloy according to claim 1 or 2, further comprising 0.1% by mass or more and less than 3% by mass of Ag.

4. The solder alloy according to any one of claims 1 to 3, further comprising at least one of Al, Ti, Si, Fe, and Ge in a total amount of 0.003% by mass or more and 0.5% by mass or less.

5. A solder bonding material comprising the solder alloy according to any one of claims 1 to 4.

6. A solder paste comprising: a powder composed of the solder alloy according to one of claims 1 to 4; and a flux.

7. A semiconductor package comprising: a substrate; a semiconductor element; and a bonding portion bonding the substrate and the semiconductor element, wherein
the bonding portion is formed by using the solder bonding material according to claim 5.

8. A semiconductor package comprising: a substrate; a semiconductor element; and a bonding portion bonding the substrate and the semiconductor element, wherein
the bonding portion is formed by using the solder paste according to claim 6.

# FIG. 1

# FIG. 2

## FIG. 3

(a)

(b)

## INTERNATIONAL SEARCH REPORT

| International application No. |
| --- |
| **PCT/JP2022/008701** |

### A. CLASSIFICATION OF SUBJECT MATTER

*B23K 35/26*(2006.01)i; *B23K 35/22*(2006.01)i; *C22C 13/02*(2006.01)i; *H05K 3/00*(2006.01)i
FI:    B23K35/26 310A; C22C13/02; B23K35/22 310A; H05K3/00 W

According to International Patent Classification (IPC) or to both national classification and IPC

### B. FIELDS SEARCHED

Minimum documentation searched (classification system followed by classification symbols)

B23K35/26; B23K35/22; C22C13/02; H05K3/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | WO 2019/058650 A1 (SENJU METAL INDUSTRY CO., LTD.) 28 March 2019 (2019-03-28) paragraphs [0020]-[0023], [0027], [0028], table 1 | 1-2, 5 |
| A | | 3-4, 6-8 |
| A | JP 2018-518368 A (INDIUM CORP.) 12 July 2018 (2018-07-12) | 1-8 |
| A | WO 2019/188756 A1 (SENJU METAL INDUSTRY CO., LTD.) 03 October 2019 (2019-10-03) | 1-8 |
| A | CN 109500510 A (TAMURA CORP.) 22 March 2019 (2019-03-22) | 1-8 |
| A | KR 10-2019-0028985 A (TAMURA CORP.) 20 March 2019 (2019-03-20) | 1-8 |

☐ Further documents are listed in the continuation of Box C.    ☑ See patent family annex.

| | |
| --- | --- |
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
| --- | --- |
| **06 May 2022** | **17 May 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/008701**

| Patent document cited in search report | | | Publication date (day/month/year) | Patent family member(s) | | | Publication date (day/month/year) |
|---|---|---|---|---|---|---|---|
| WO | 2019/058650 | A1 | 28 March 2019 | US | 2019/0358751 | A1 | |
| | | | | paragraphs [0032]-[0040], [0045], [0046], table 1 | | | |
| | | | | EP | 3513900 | A1 | |
| | | | | SG | 11201903430P | A | |
| | | | | CN | 109963684 | A | |
| | | | | BR | 112019008146 | A2 | |
| | | | | MX | 2019004644 | A | |
| | | | | JP | 2019-55410 | A | |
| | | | | PH | 12019500835 | A1 | |
| JP | 2018-518368 | A | 12 July 2018 | US | 2016/0325384 | A1 | |
| | | | | US | 2020/0094353 | A1 | |
| | | | | WO | 2016/179358 | A1 | |
| | | | | EP | 3291942 | A1 | |
| | | | | EP | 3838473 | A1 | |
| | | | | TW | 201704491 | A | |
| | | | | KR | 10-2018-0006928 | A | |
| | | | | CN | 107635716 | A | |
| | | | | CN | 113146093 | A | |
| | | | | TW | 2021126827 | A | |
| WO | 2019/188756 | A1 | 03 October 2019 | US | 2021/0114143 | A1 | |
| | | | | EP | 3778107 | A1 | |
| | | | | KR | 10-2020-0117042 | A | |
| | | | | CN | 111902238 | A | |
| | | | | SG | 11202009069Y | A | |
| | | | | BR | 112020019110 | A2 | |
| | | | | TW | 201941862 | A | |
| | | | | JP | 2019-181561 | A | |
| | | | | MY | 185339 | A | |
| | | | | PH | 12020551553 | A1 | |
| CN | 109500510 | A | 22 March 2019 | (Family: none) | | | |
| KR | 10-2019-0028985 | A | 20 March 2019 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6516013 B
- JP 6642865 B
- JP 6773143 B